(19) **Europäisches Patentamt European Patent Office Office européen des brevets**

(11) **EP 2 140 571 B1**

(12) **EUROPEAN PATENT SPECIFICATION**

(45) Date of publication and mention
of the grant of the patent:
**01.06.2011 Bulletin 2011/22**

(51) Int Cl.:
*H04B 7/005* (2006.01)          *H04B 17/00* (2006.01)
*H03G 3/30* (2006.01)          *H04B 1/04* (2006.01)

(21) Application number: **08743142.5**

(22) Date of filing: **19.04.2008**

(86) International application number:
**PCT/US2008/005121**

(87) International publication number:
**WO 2008/130693 (30.10.2008 Gazette 2008/44)**

(54) **APPARATUS AND METHOD FOR COMPUTING MAXIMUM POWER REDUCTION FOR A UMTS SIGNAL**

VORRICHTUNG UND VERFAHREN ZUR BERECHNUNG DER MAXIMALEN LEISTUNGSREDUKTION FÜR EIN UMTS-SIGNAL

DISPOSITIF ET PROCÉDÉ POUR CALCULER UNE RÉDUCTION DE PUISSANCE MAXIMUM D'UN SIGNAL UMTS

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **20.04.2007 US 912947 P**
**08.02.2008 US 27281**

(43) Date of publication of application:
**06.01.2010 Bulletin 2010/01**

(73) Proprietor: **InterDigital Technology Corporation**
**Wilmington, DE 19810 (US)**

(72) Inventors:
• **HAIM, John, W.**
**Baldwin, NY 11510 (US)**
• **VETTER, Kurt, G.**
**East Quogue, NY 11942 (US)**

(74) Representative: **Nordin, Magnus et al**
**Awapatent AB**
**P.O. Box 45086**
**104 30 Stockholm (SE)**

(56) References cited:
**EP-A- 1 617 575**

• **JOSHIN K ET AL: "HARMONIC FEEDBACK CIRCUIT EFFECTS ON INTERMODULATION PRODUCTS AND ADJACENT CHANNEL LEAKAGE POWER IN HBT POWER AMPLIFIER FOR 1.95 GHZ WIDE-BAND CDMA CELLULAR PHONES" IEICE TRANSACTIONS ON ELECTRONICS, ELECTRONICS SOCIETY, TOKYO, JP, vol. E82-C, no. 5, 1 May 1999 (1999-05-01), pages 725-729, XP000919543 ISSN: 0916-8524**

**Description**

FIELD OF INVENTION
This application is related to wireless communications.
BACKGROUND
In practical amplifier circuits, such as those in a Universal Mobile Telecommunications System (UMTS) Wireless Transmit Receive Unit (WTRU) transmit chain, the cause of spectral re-growth is due to nonlinear amplifier characteristics. The term spectral re-growth describes the increase in out-of-band signal energy at the power amplifier output. Spectral re-growth due to non-linear amplifier effects is most pronounced within a channel adjacent to a desired transmit channel. For UMTS, the requirement on the power amplifier is defined by an Adjacent Channel Leakage Ratio (ACLR) at +/-5MHz of the desired channel. The amplifier voltage gain characteristic is as follow:

$$v_o(t) = g_1 \cdot v_i(t) + g_2 \cdot v_i(t)^2 + g_3 \cdot v_i(t)^3 + ... + g_n \cdot v_i(t)^n$$

Equation (1)
.

where $g_1 \cdot v_i(t)$ is the linear gain of the amplifier and the remaining terms (i.e., $g_2 \cdot v_i(t)^2 + g_3 \cdot v_i(t)^3 + ... + g_n \cdot v_i(t)^n$) represent the non-linear gain. If the signal carries a modulated third Generation Partnership Project (3GPP) Radio Frequency (RF), then the non-linear terms will be generated as a result of inter-modulation distortion, resulting in in-band distortion terms causing an increase in Error Vector Magnitude (EVM) and out-of-band distortion causing an increase in ACLR. Both effects cause a reduction of modulation quality.
Multi-code signals, such as those in UMTS Release 5 and Release 6, exhibit an increase in peak-to-average power resulting in larger dynamic signal variations. These increased signal variations require increased amplifier linearity, resulting in increased power consumption. Recent results have shown that it is not efficient to directly transfer dB for dB (i.e., the ratio of peak power to average power of a signal, also known as peak-to-average ratio (PAR)) to amplifier power reduction. Analysis of the amplifier spectral re-growth has shown that the 3rd order non-linear gain term ("cubic gain") is the dominant cause of ACLR increase. The total energy in the cubic term is dependent on the statistical distribution of the input signal.
With the introduction of High Speed Uplink Packet Access (HSUPA), a new method of estimating amplifier power reduction called the Cubic Metric (CM) was introduced in Release 6. The CM is based on the amplifier cubic gain term. The CM describes the ratio of the cubic components in the observed signal to the cubic components of a 12.2 kbps voice reference signal. The CM applies to both High Speed Downlink Packet Access (HSDPA) and HSUPA uplink signals. Statistical analysis has shown that the power de-rating based on an estimation of the CM exhibits a significantly smaller error distribution when compared to power de-rating based on 99.9% PAR, where the error distribution is the difference between the actual power de-rating and the estimated power de-rating.
European patent application EP 1 617 575 discloses a method and an apparatus for controlling transmission electric power capable of minimizing a decrease in the amount of maximum transmission electric power without degrading an adjacent channel leakage power ratio when code-multiplexing additional control information with data and main control information. A mobile device checks values of gain factors βd and βc when performing code multiplexing to transmit signals from channels DPDCH to transmit data, DPCCH to transmit main control information, and HS-DPCCH to transmit additional control information. A maximum transmission electric power is decreased at a plurality of levels based on the check result and a ratio (Δhs) between the gain factors βc and βhs. It may be preferable to check the presence or absence of transmission data instead of the gain factor βd. In this case, when no transmission data is available, the maximum transmission electric power is decreased at a plurality of levels based on Δhs. When transmission data is available, the maximum transmission electric power is decreased at a plurality of levels based on the gain factor βc and Δhs.
3GPP specifies a Maximum Power Reduction (MPR) test which verifies that the maximum transmit power of a WTRU is greater than or equal to the nominal maximum transmit power less an amount herein termed "maximum-MPR," where maximum-MPR is a function of the transmitted signal's CM. For a given power amplifier, the manufacturer could determine that its device could allow that maximum power need only be limited to some amount, herein termed "minimum-MPR," that is less than maximum-MPR, and yet remain 3GPP ACLR compliant. While "minimum-MPR" could be specified as a function of CM, it is possible that it could alternatively be specified as a function of a particular percentage PAR. Limiting maximum power by minimum-MPR rather than maximum-MPR allows the WTRU to transmit at a higher maximum power and thus provides a WTRU manufacturer exploiting minimum-MPR with a competitive advantage. It is possible that a particular WTRU's design could include determining both maximum-MPR and minimum-MPR and making a selection between the two.
Regardless of the choice of using maximum-MPR or minimum-MPR, a key issue is that the WTRU must know the value of CM and/or PAR in order to compute the selected MPRs and, if required, (i.e., if the WTRU is operating at near maximum power), ultimately use them to actually set the transmit power. Any multicode signal (characterized by the physical channels being transmitted, their channelization codes and weights called βterms) has its particular CM and PAR.

[0009]     In UMTS, the signal, and thus the CM and PAR, can change every 2 or 10 msec Transmit Time Interval (TTI). It can be shown that for Release 6 UMTS there are over two hundred thousand combinations of physical channel parameters and quantized β terms; each such combination is herein termed a possible signal. The large number of possible signals makes a strict one-to-one a priori determined lookup of CM or PAR as a function of signal characteristics impractical to implement in real time; particularly in a small lower power handheld device operating at UMTS data rates. Recognizing that it is impractical for a WTRU to simply look up CM or PAR, it is necessary to either measure them or estimate them within some allowable error, from the signal's characteristic parameters.

Measuring CM or PAR from the actual signal is well known. A key defect in this is that the signal must first be created in order to make the measurement. Since transmit power may ultimately be set as a function of CM and/or PAR, setting the power by measurement will require a signal, or at least some time limited segment of it, to be generated before it is transmitted. While in theory this is possible, the time latency requirement of UMTS and practical memory limitations makes this approach also impractical.

A variant of the above approach is to generate and start transmitting the signal at some transmit power level computed from a "guess" of CM or PAR and then adjust the transmit power for the remaining whole timeslots in a TTI to a second power level. The mix of first and second power levels is computed such that, on average, the power level is close to the level that would have been selected had CM or PAR been known prior to the start of the TTI.

In UMTS there are 15 timeslots in a 10 msec TTI, but only three timeslots in a 2 msec TTI. Assuming, for example, that the measurement of CM or PAR takes some fraction of one timeslot to complete, for a 10 msec TTI, the initial power level would be set for only the first timeslot, and the remaining 14 timeslots would have the second value. For a 2 msec TTI, the initial power level would be set for the first timeslot, which is one-third of the TTI, and only the remaining two-thirds of the TTI would have the second power. It is not apparent that such a method could be compliant, especially in the 2 msec TTI case. Therefore, there exists a need for a method of determining CM or PAR to determine maximum-MPR and/or minimum-MPR, and ultimately the transmit power, before the signal starts to be transmitted.

SUMMARY

A method and apparatus are provided for controlling transmit power with an estimated value of CM or PAR through estimation. The method may be applied in determining a value for Maximum Power Reduction (MPR) for a computing maximum-MPR or minimum-MPR by estimating CM or PAR from signal parameters, as opposed to directly measuring CM or PAR. The method of estimating CM or PAR is applicable to any multicode signal.

According to an aspect of the present invention, there is provided a method implemented in a wireless transmit receive unit (WTRU) for computing a maximum power reduction (MPR), the method being characterised in comprising: identifying a configuration case from a set of configuration cases predefined according to characteristics of a received signal; adjusting an estimated cubic metric (CM) by a preconfigured adjustment factor for the configuration case, where the CM is based on a transmit power amplifier cubic gain term and the estimated CM is stored in the WTRU from an initial configuration; computing the MPR based on the adjusted estimated CM; and setting transmit power using the MPR.

According to another aspect of the present invention, there is provided a wireless transmit receive unit (WTRU) being characterised in comprising a processor, the processor configured to: identify a configuration case from a set of configuration cases predefined according to characteristics of a received signal; adjust an estimated cubic metric (CM) by a preconfigured adjustment factor for the configuration case, where the CM is based on a transmit power amplifier cubic gain term and the estimated CM is stored in the WTRU from an initial configuration; compute the MPR based on the adjusted estimated CM; and set transmit power using the MPR.

BRIEF DESCRIPTION OF THE DRAWINGS

A more detailed understanding of the invention may be had from the following description of a preferred embodiment, given by way of example and to be understood in conjunction with the accompanying drawings wherein:

Figure 1 is a functional block diagram of a Wireless Transmit Receive Unit (WTRU) in accordance with the present disclosure;

Figure 2 is a block diagram of a simplified version of an off-line processor;

Figure 3 is a flow diagram of detailed version of an off-line initial configuration process;

Figure 4 is a block diagram of a WTRU in accordance with an embodiment;

Figures 5A and 5B are two graphs, for the model in Equation 5 and the model in Equation 6, respectively, depicting the distribution of maximum-MPR estimation errors;

Figures 6A and 6B are two graphs, for the model in Equation 5 and the model in Equation 6, respectively, depicting the distribution of CM estimation errors;

Figures 7A and 7B are two graphs, for the model in Equation 5 and the model in Equation 6, respectively, depicting the distribution of PAR estimation errors; and

Figure 8 is a flow diagram of a method of setting transmit power.

DETAILED DESCRIPTION

When referred to hereafter, the terminology "wireless transmit/receive unit (WTRU)" includes but is not limited to a user equipment (UE), a mobile station, a fixed or mobile subscriber unit, a pager, a cellular telephone, a personal digital assistant (PDA), a computer or any other type of user device capable of operating in a wireless environment.

When referred to hereafter, the terminology "base station" includes but is not limited to a Node-B, a site controller, an access point (AP), or any other type of interfacing device capable of operating in a wireless environment.

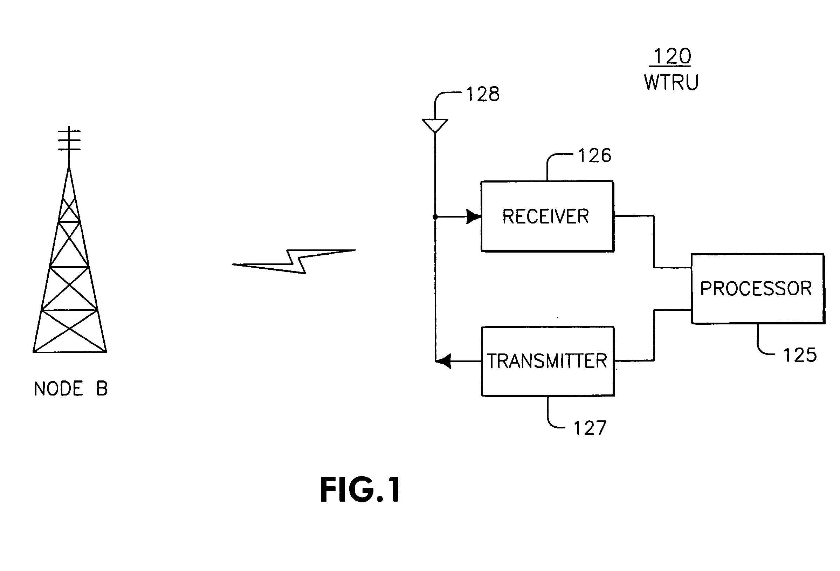

Figure 1 is a diagram of a WTRU 120 configured to perform the method disclosed hereinafter. In addition to components included in a typical WTRU, the WTRU 120 includes a processor 125 configured to perform the disclosed method, a receiver 126, which is in communication with the processor 125, a transmitter 127, which is in communication with the processor 125, an antenna 128 which is in communication with the receiver 126 and the transmitter 127 to facilitate the transmission and reception of wireless data. The WTRU wirelessly communicates with a base station 110.

A method of estimating transmit CM and/or PAR of a signal based on the signal's configurable parameters, and applying the estimate to compute the MPR will now be described herein. Configurable parameters include the number and type of physical channels and a configuration case. A configuration case may be defined as a particular combination of channelization code and channel weight (termed $\beta$), preferably for both codes in-phase (I) and quadrature channel (Q) components. Channel weight (for a given service and data rate), the other parameters, referred to below as "configuration," and all combinations of which may be determined based on requirements specified in 3GPP.

A signal may be defined as combination of a physical channel and a $\beta$ term. Each possible signal must be in at least one configuration case. The definition could be expanded. For example, it may include a subset or limited range of some or all $\beta$ terms for one or more of the physical channels comprising a configuration case. The identification of a minimal set of configuration cases which yields acceptably small CM and/or PAR estimation errors, which in turn drive the MPR estimation error, is subjective.

An example set of eleven configuration cases is shown in Table 1. These configuration cases are limited to allowing up to one DPDCH. Those of skill in the art would realize that the configuration cases need not be so limited. However, most likely they are suboptimal. Empirical results shown yield acceptably small estimation errors, specifically, that the largest maximum-MPR estimation error is less than or equal to 1.5 dB. Table 1, shows that the configuration cases are defined by the three main characteristics: 1) the maximum number of DPDCHs (Nmax DPDCH); 2) whether or not High Speed (HS) is enabled; and 3) the number and Spreading Factors (SFs) of E-DPDCHs (E-DPDCH codes @ SF). An alternative mapping is given in Table 2. Table 2, shows that dividing some of the cases originally defined in Table 1 into multiple cases results in smaller errors than the mapping of Table 1. Specifically, it shows that the largest maximum-MPR estimation error is less than or equal to 1.0 dB.

Referring back to Table 1, the HS Chan Code column refers to the specific "SF and an Orthogonal Variable (OV)SF code" used for the HS-DPCCH. Note that SF is always 256, and for OVSF one of two codes (33 and 64) is used. This column is shown as 'not applicable' (N/A) when the third column (i.e., HS) indicates there is no ('N') HS.

The E-DPDCH 1, 3 I or Q column indicates in which leg, I or Q, E-DPDCH channels #1 and #3 appear, that is used in context of the columns.

The E-DPDCH 1, 3 Chan Code column refers to the SF and OVSF code for the E-DPDCH, if any, referred to as channel #1 and #3. For example, Configuration Case 6 has two E-DPDCHs, labeled as #1 and #3, the rest of the column either have none (not applicable) or one (by default "#1"). Most configuration cases have just one E-DPDCHs.

The E-DPDCH 2,4 Chan Code column is similar to the above, for the cases where there are two or more E-DPDCHs.

The I and Q columns show $\beta$ values in the I and Q legs. In configuration case 6, $\beta_{ed}$ refers to E-DPDCH channels #1 and #2, and $\beta_{ed3/4}$ refers to E-DPDCH channels #3 and #4.

**Table 1**

| Config. Case | Nmax DPDCH | HS | E-DPDCH codes@SF | HS Chan Code | E-DPDCH 1,3 I or Q | E-DPDCH 1,3 Chan Code | E-DPDCH 2,4 Chan Code | I | Q |
|---|---|---|---|---|---|---|---|---|---|
| 0 | 1 | N | 0 | N/A | N/A | N/A | N/A | $\beta_d$ | $\beta_c$ |
| 1 | 0 | Y | 1@SF>=4 | 256,33 | I | SF,SF/4 | N/A | $\beta_{ec}, \beta_{ed}$ | $\beta_c, \beta_{hs}$ |
| 2 | 0 | N | 1@SF>=4 | N/A | I | N/A | N/A | $\beta_{ec}, \beta_{ed}$ | $\beta_c$ |
| 3 | 0 | Y | 0 | 256,33 | I | SF,SF/4 | N/A | N/A | $\beta_c, \beta_{hs}$ |

4

(continued)

| Config. Case | Nmax DPDCH | HS | E-DPDCH codes@SF | HS Chan Code | E-DPDCH 1,3 I or Q | E-DPDCH 1,3 Chan Code | E-DPDCH 2,4 Chan Code | I | Q |
|---|---|---|---|---|---|---|---|---|---|
| 4 | 0 | Y/N | 2@SF=4 | 256,33 | I | SF,SF/4 =4,1 | 4,1 | $\beta_{ec}$, $\beta_{ed}$ | $\beta_c$, $\beta_{hs}$ $\beta_{ed}$ |
| 5 | 0 | Y/N | 2@SF=2 | 256,33 | I | 2,1 | 2,1 | $\beta_{ec}$, $\beta_{ed}$ | $\beta_c$, $\beta_{hs}$ $\beta_{ed}$ |
| 6 | 0 | Y/N | 4@SF= 2/4/2/4 | 256,33 | I(#1) I (#3) | 2,1(#1) 4,1(#3) | 2,1(#1) 4,1(#3) | $\beta_{ec}$, $\beta_{ed}$, $\beta_{ed3/4}$ | $\beta_c$, $\beta_{hs}$ $\beta_{ed}$, $\beta_{ed3/4}$ |
| 7 | 1 | Y | 1@SF>=4 | 256,64 | I | SF,SF/2 | N/A | $\beta_d$, $\beta_{ec}$, $\beta_{ed}$ | $\beta_c$, $\beta_{hs}$ |
| 8 | 1 | Y/N | 2@SF=4 | 256,64 | if HS="Y" then I else Q | SF,SF/2 =4,2 | 4,2 | $\beta_d$, $\beta_{ec}$, $\beta_{ed}$ | $\beta_c$, $\beta_{hs}$ $\beta_{ed}$ |
| 9 | 1 | Y/N | 2@SF=2 | 256,64 | if HS="Y" then I else Q | SF,SF/2 =4,2 | 4,2 | $\beta_d$, $\beta_{ec}$, $\beta_{ed}$ | $\beta_c$, $\beta_{hs}$ $\beta_{ed}$ |
| 10 | 1 | N | SF>=4 | N/A | Q | SF,SF/2 | N/A | $\beta_d$, $\beta_{ec}$ | $\beta_c$, $\beta_{ed}$ |

**Table 2**

| Config Case | Nmax DPDC H | HS | E-DPDCH codes@SF | Additional Conditions |
|---|---|---|---|---|
| 0 | 1 | N | 0 | N/A |
| 1 | 0 | Y | 1@SF>=4 | N/A |
| 2 | 0 | N | 1@SF>=4 | N/A |
| 3 | 0 | Y | 0 | N/A |
| 4 | 0 | Y/N | 2@SF=4 | N/A |
| 5 | 0 | Y/N | 2@SF=2 | N/A |
| 6 | 0 | Y/N | 4@SF= 2/4/2/4 | N/A |
| 7a | 1 | Y | 0, or 1@SF>=4 | $\beta_c - \beta_d > 0$ |
| 7b | | | | $\beta_c - \beta_d \leq 0$ |
| 8a | 1 | Y/N | 2@SF=4 | $\beta_c - \beta_d > 0$ $15*A_{ed}=5$ |
| 8b | | | | $\beta_c - \beta_d > 0$ |
| 8c | | | | $\beta_c - \beta_d \leq 0$ $15*A_{ed}=5$ |
| 8d | | | | $\beta_c - \beta_d \leq 0$ $15*A_{ed}\sim=5$ |
| 9a | 1 | Y/N | 2@SF=2 | $\beta_c - \beta_d > 0$ |
| 9b | | | | $\beta_c - \beta_d \leq 0$ $15*A_{ed}=5$ |
| 9c | | | | $\beta_c - \beta_d \leq 0$ $15*A_{ed}\sim=5$ |
| 10 | 1 | N | 1@SF>=4 | N/A |

Configuration case 0 in Table 1 and Table 2 is a trivial case known to require zero maximum-MPR. For this configuration case, the computational method for all other configuration cases should not be applied; rather, maximum-MPR and/or minimum-MPR should simply be set to zero.

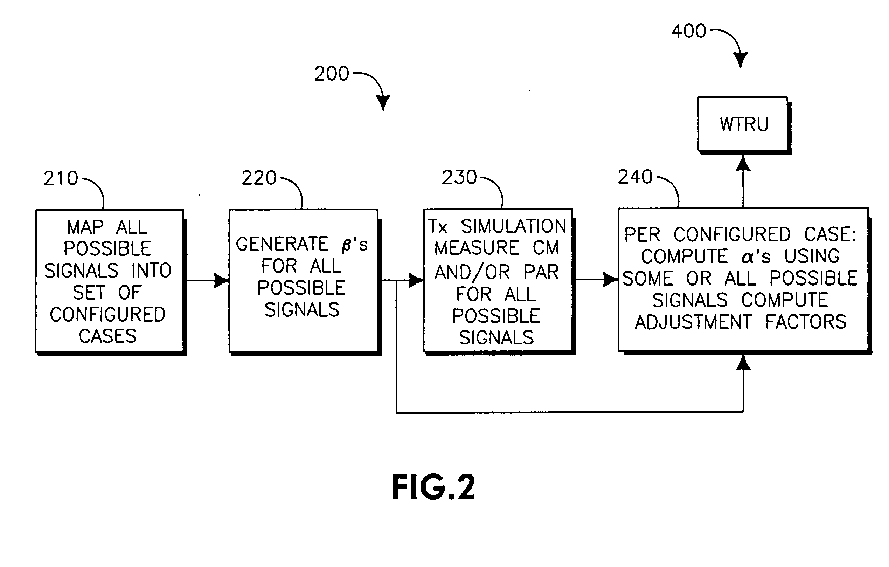

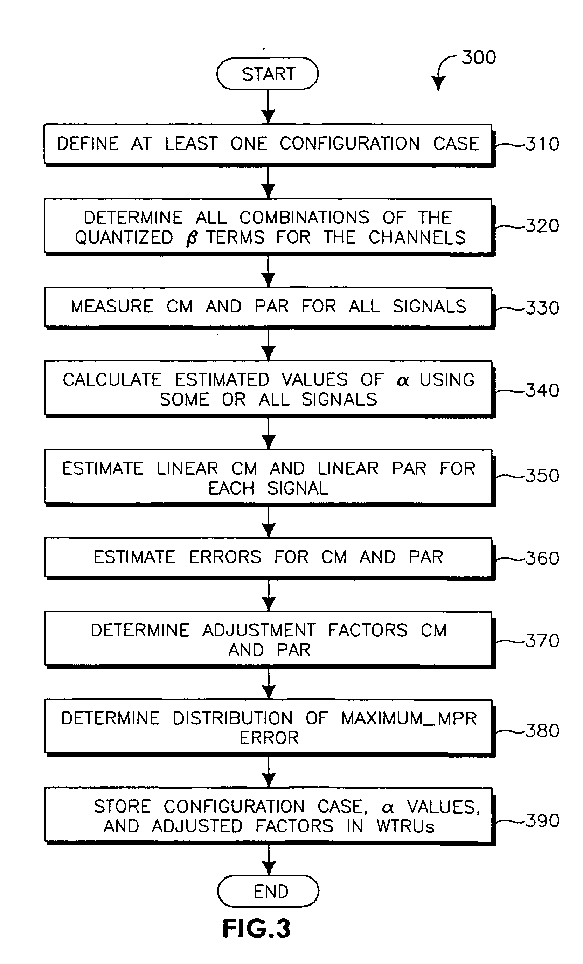

Referring to Figure 2, a simplified version of an off-line process 200 is shown. As will be explained in greater detail hereinafter with respect to Figure 3, the process 200 ultimately computes and stores parameters for use by a WTRU to generate maximum-MPR and/or minimum-MPR values. In UMTS, each combination of a physical channel parameter and a quantized term $\beta$ is a possible signal. The quantized term is based on a configuration of the signal. First, all possible signals are mapped into set of configuration cases (210). Using information given in the two rightmost columns of Table 1 (I and Q), the quantized terms are generated for all possible signals (220). The CM and/or PAR for all possible signals are measured by a transmitter simulation (230). The measurement of CM and PAR will be described in greater detail hereinafter.

The pre-computed terms $\alpha$ are preferably determined 240 using the output of the transmitter simulation 230. One set of $\alpha$ terms, computed based on Equation 7 hereinafter, for CM and/or one set for PAR is preferably determined for each configuration case defined above.

For each configuration case, the transmitter simulation 230 measures CM and PAR for all possible signals, (the mathematical derivation of estimating CM and/or PAR is derived in detail hereinafter), here defined as all possible combinations of quantized $\beta$ terms 220 per 3GPP. The technique of least square fitting may be used to determine the values of pre-computed terms $\alpha$ for a specific configuration case, either from all possible signals of the configuration case or from a sample subset thereof. The computed $\alpha$ terms, the configuration case, and computed adjustment factors are calculated (240). These values are later built into a WTRU 400 via firmware, software or hardware.

Figure 3 is a flow diagram of an off-line initialization configuration process (300). The process 300 computes the $\alpha$ terms for both CM and PAR, and determines the adjustment factors for a configuration case. These values are stored in a WTRU (400) for a given signal's estimates CM and PAR.

**[0044]** Referring to Figure 3, a detailed version of an off-line process 300 is shown. First, a configuration case according to a characteristic of a physical channel is defined at 310. For example, illustrated as the configuration case 9 in Table 1, DPCCH, one DPDCH (maximum of one DPDCH), HS-DPCCH ($\Delta_{ACK}$ and $\Delta_{CQI}$ set identically; positive acknowledgement (ACK) and channel quality indication (CQI) always transmitted), E-DPCCH and 2@SF=2 (two E-DPDCHs at SF equal to two) is defined.

The required individual, squared, and intra-component cross $\beta$ terms are determined (320), using the information given in the two rightmost columns of Table 1 (I and Q). From the notation of Equation 5 (described hereinafter), $\{\beta_{I1} \, \beta_{I2} \, \beta_{I3}\} = \{\beta_d \, \beta_{ec} \, \beta_{ed}\}$ and $\{\beta_{Q1}/\beta_{Q2} \, \beta_{Q3}\} = \{\beta_c \, \beta_{hs} \, \beta_{ec}\}$ (the particular numerical designations are arbitrary). There are sixteen such terms defined in Table 3: $\beta_{ec}, \beta_{ed}, \beta_d, \beta_c, \beta_{hs}, \beta_{ec}^2, \beta_{ed}^2, \beta_d^2, \beta_c^2, \beta_{hs}^2, \beta_{ec}\beta_{ed}, \beta_{ec}\beta_d, \beta_{ed}\beta_d, \beta_c\beta_{hs}, \beta_c\beta_{ed},$ and $\beta_{hs}\beta_{ed}$.

All possible signals, (i.e., all combinations of the quantized $\beta$ terms for the channels) of the configuration case are then determined (320). Per 3GPP, there are implicitly thirty combinations of paired values of $\beta_c$ and $\beta_d$, explicitly nine values of $A_{hs} = \beta_{hs}/\beta_c$, nine values of $A_{ec} = \beta_{ec}/\beta_c$ and thirty values of $A_{ed}, = \beta_{ed}/\beta_c$, or 72,900 possible signal combinations for each configuration case in total. The 72,900 combinations are not listed here.

A transmitter simulation is used to measure CM and measure 99% PAR for all 72,900 possible signals in each configuration case (330). The 145,800 measured values are not listed here.

Using the 72,900 possible signals in each configuration case and their measured values of linear CM and linear PAR, the sixteen pre-computed a values for estimating CM and the sixteen pre-computed $\alpha$ values for estimating PAR are calculated (340) using Equation 7. The symbolic terms are given in Equations 8 through Equations 11; the numerical values of the $\alpha$ terms are given in Table 3. Although only a small subset of the 72,900 combinations can be used, given that the matrix *X* with 72,900 rows is needed in the next step, the full set of 72,900 combinations is used for computation of Table 3 of one configuration case.

**Table 3**

| Function of $\beta$ terms | $\alpha_{CM}$ | $\alpha_{PAR}$ |
|---|---|---|
| $\beta_{ec}$ | -1.53154 | -0.0333305 |
| $\beta_{ed}$ | -1.04303 | +1.97253 |
| $\beta_d$ | -1.88422 | -0.691914 |
| $\beta_c$ | -1.10666 | -1.24791 |
| $\beta_{hs}$ | -0.851261 | -0.642072 |
| $\beta_{ec}^2$ | +2.7545 | +2.3413 |
| $\beta_{ed}^2$ | +3.39477 | +1.35334 |

(continued)

| Function of β terms | $\alpha_{CM}$ | $\alpha_{PAR}$ |
|---|---|---|
| $\beta_d{}^2$ | +2.85157 | +2.61758 |
| $\beta_c{}^2$ | +2.47229 | +2.86022 |
| $\beta_{hs}{}^2$ | +2.37892 | +2.63543 |
| $\beta_{ec}\,\beta_{ed}$ | +2.33816 | +1.72716 |
| $\beta_{ec}\,\beta_d$ | +2.18533 | +1.27585 |
| $\beta_{ed}\,\beta_d$ | +2.95673 | +2.75154 |
| $\beta_c\,\beta_{hs}$ | +1.75287 | +1.80679 |
| $\beta_c\,\beta_{ed}$ | +2.05286 | +3.06353 |
| $\beta_{hs}\,\beta_{ed}$ | +1.59968 | +2.07734 |

For each of the possible signals, linear CM and linear PAR are estimated (350) using the model described by Equations 5 and 6 (described hereinafter). The computation, in matrix form, is given in Equation 12. Matrix $X$ is the numerator of Equation 5 and includes the normalization function for the single β terms. Matrix $Y$ is the linear CM and linear PAR measurements multiplied by the denominator of Equation 5; a similar form is used for the model of Equation 6.

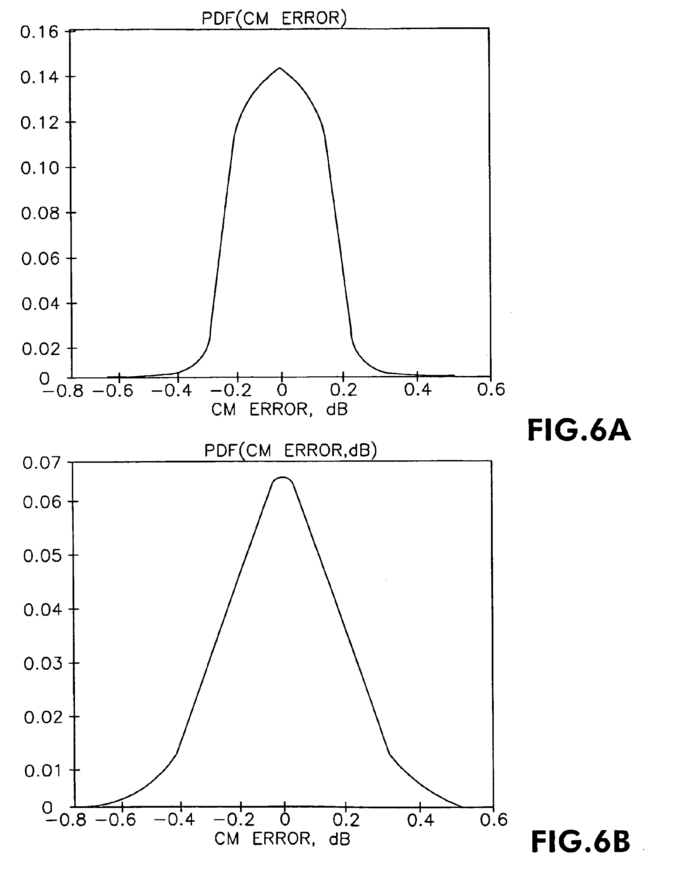

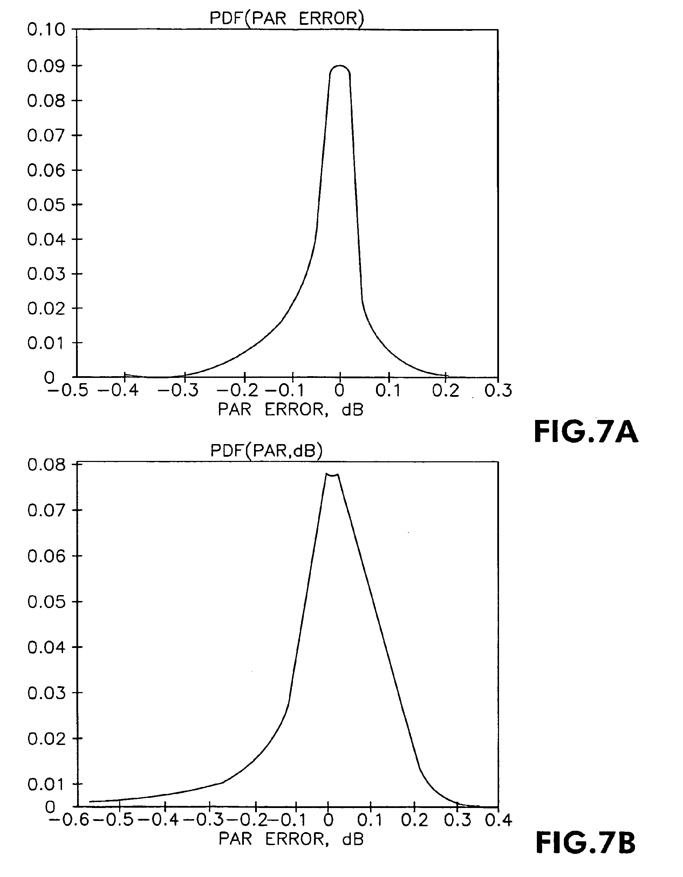

The estimation errors for both CM and PAR are preferably calculated (360) using Equation 13. To illustrate further, the distribution of the CM estimation errors (in dB) is given in Figures 6A and 6B. The distribution of the PAR estimation errors, in dB, is given in Figures 7A and 7B. Figures 6A and 7A represent the model described in Equation 5. Whereas, Figures 6B and 7B represent the model described in Equation 6.

The requisite adjustment factors are the determined (370). By inspection it can be seen that for the model of Equation 5, the adjustment factor for maximum-MPR, the largest magnitude positive error in Figure 6A, is approximately 0.54 dB or 1/0.883. If minimum-MPR was the desired result, the adjustment factor for minimum-MPR using CM, the largest magnitude negative error in Figure 6A, is approximately -0.71 dB. The adjustment factor for minimum-MPR using PAR, the largest magnitude negative error in Figure 7A, is approximately -0.41 dB. The corresponding values for the model of Equation 6, obtained by inspection of Figure 6B and Figure 7B, are 0.54 dB, -0.20 dB, and - 0.57 dB.

The distribution of maximum-MPR error is determined (380), by applying the adjustment factors, coincidently both being 0.54 dB, as computed above.

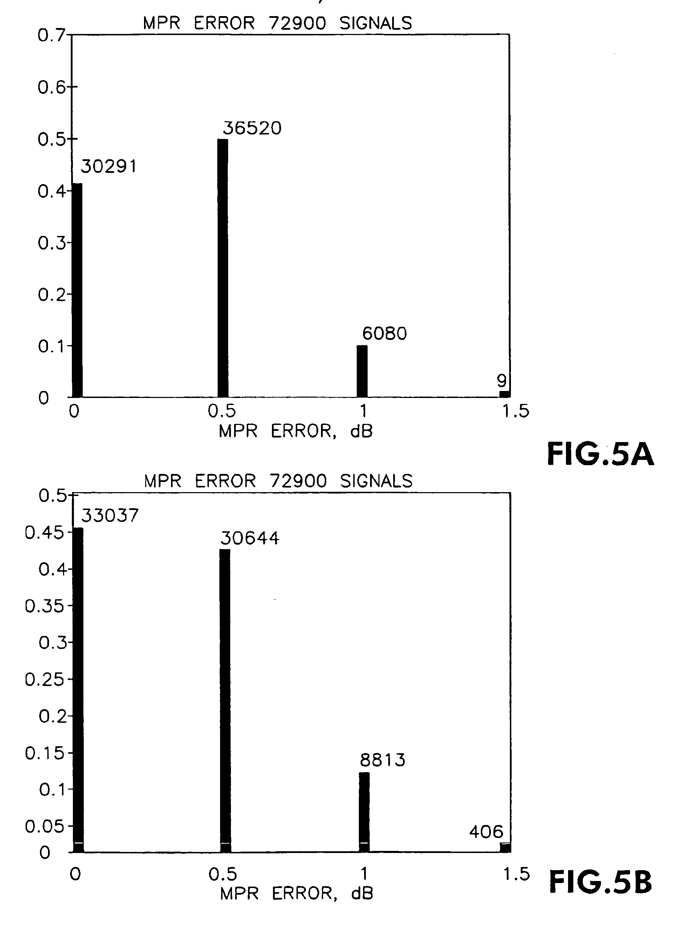

Inspection of Figure 5A and Figure 5B, the distributions of maximum-MPR error, shows that for both models, the maximum of the maximum-MPR error is 1.5 dB, if this is deemed sufficiently small, (which in this example it is) nominally either model can be used.

As secondary criteria, it should be noted that the frequency of occurrence of the maximum error for the model of Equation 5, specifically 9/72,900, is lower than that of the model of Equation 6, specifically, 406/72,900, as illustrated in Figures 5A and 5B. Thus the model of Equation 5 is chosen and its α values and adjustment factor (390) are configured in the WTRU (400). Alternatively, the model of Equation 6 requires fewer multiplications to estimate CM, and that model could have been chosen if that is a significant factor.

The derivation of estimating CM and/or PAR will now be described. The PAR of the uplink signal after the channel weights have been applied, but before the root raised cosine (RRC) and other filters are applied, is determined in accordance with Equation 2.

$$PAR = 10\log\left(PAR_{linear}\right) = 10\log\left(\frac{\left(\sum_{j=1}^{N_I}\beta_{I_j}\right)^2 + \left(\sum_{j=1}^{N_Q}\beta_{Q_j}\right)^2}{\sum_{j=1}^{N_I}\beta_{I_j}{}^2 + \sum_{j=1}^{N_Q}\beta_{Q_j}{}^2}\right)\ ;$$

Equation (2)

where;

$\beta_I$ is the channel weight for a physical channel in the I component;

$\beta_Q$ is the channel weight for a physical channel in the Q component;

$N_I$ is the number of physical channels in the I component; and

$N_Q$ is the number of physical channels in the Q component.

In accordance with one embodiment, for a given configuration case, $CM_{linear}$, (CM in linear - not dB - form, and without the 0.5 dB quantization of the method of 3GPP), is preferably estimated as a function related to the pre-filter $PAR_{linear}$ of Equation 2, as per Equation 3:

$$CM_{linear} \approx \frac{\sum_{n=1}^{N_{Order}}\left(f_{nrm}(\overline{\beta},n)\sum_{j=1}^{N_I}\gamma_j\beta_{I_j}\right)^n + \sum_{n=1}^{N_{Order}}\left(f_{nrm}(\overline{\beta},n)\sum_{j=1}^{N_Q}\gamma_j\beta_{Q_j}\right)^n}{\sum_{j=1}^{N_I}\beta_{I_j}^2 + \sum_{j=1}^{N_Q}\beta_{Q_j}^2} ;$$

Equation (3)

where;

$y_j$ are real weighting factors for each physical channel;

n is an integer that defines an index of a summation;

$N_{Order}$ is an arbitrary polynomial order; and $f_{nrm}(\overline{\beta},n) = \left(\sum_{j=1}^{N_I}\beta_{I_j}^2 + \sum_{j=1}^{N_Q}\beta_{Q_j}^2\right)^{\frac{2-n}{2}}$ is a normalization function that makes

the values of $\gamma_j$ independent of arbitrary scaling of the $\beta$ terms.

$PAR_{linear}$ at the output of the filters may also be estimated using the same function as in Equation 3, with only the values of the $\gamma$ terms being different from those for $CM_{linear}$. For any possible signal of a given configuration case, using Equation 3 to estimate $CM_{linear}$, $PAR_{linear}$ will generally result in a difference between estimated values and measured values; this is referred to as the estimation error.

While $N_{Order}$ may be selected as any positive integer, in one embodiment, for example, it is $N_{Order}$=2. Empirical results show that by using $N_{Order}$=2, the range of estimation errors for all possible signals is acceptably small for determining maximum-MPR and minimum-MPR. Thus, selecting $N_{Order}$ greater than 2 results in additional complexity but no vital performance improvement. Accordingly, Equation 3 is simplified when $N_{Order}$ is set to 2 as shown in Equation 4:

$$CM_{linear} \approx \frac{\left(\sum_{j=1}^{N_I}\gamma_j\beta_{I_j}\right)^2 + \left(\sum_{j=1}^{N_Q}\gamma_j\beta_{Q_j}\right)^2 + \sqrt{\sum_{j=1}^{N_I}\beta_{I_j}^2 + \sum_{j=1}^{N_Q}\beta_{Q_j}^2}\left(\sum_{j=1}^{N_I}\gamma_j\beta_{I_j} + \sum_{j=1}^{N_Q}\gamma_j\beta_{Q_j}\right)}{\sum_{j=1}^{N_I}\beta_{I_j}^2 + \sum_{j=1}^{N_Q}\beta_{Q_j}^2} .$$

Equation (4)

Expanding Equation 4 yields Equation 5.

$$CM_{linear} \approx \frac{\sum\limits_{j=1}^{N_I}\alpha_j\beta_{I_j}^2 + \sum\limits_{j=1}^{N_I}\sum\limits_{k=j+1}^{N_I}\alpha_{j,k}\beta_{I_j}\beta_{I_k} + \sum\limits_{j=1}^{N_Q}\alpha_j\beta_{Q_j}^2 + \sum\limits_{j=1}^{N_Q}\sum\limits_{k=j+1}^{N_Q}\alpha_{j,k}\beta_{Q_j}\beta_{Q_k} + \sqrt{\sum\limits_{j=1}^{N_I}\beta_{I_j}^2 + \sum\limits_{j=1}^{N_Q}\beta_{Q_j}^2}\left(\sum\limits_{j=1}^{N_I}\alpha_j\beta_{I_j} + \sum\limits_{j=1}^{N_Q}\alpha_j\beta_{Q_j}\right)}{\sum\limits_{j=1}^{N_I}\beta_{I_j}^2 + \sum\limits_{j=1}^{N_Q}\beta_{Q_j}^2}$$

Equation (5)

which expresses $CM_{linear}$ as being approximately equal to a weighted version of the inner product of squared weighted-individual (weighted by the square root term), intra-component cross β terms, along with the α terms that are still unknown. The formulation similarly applies to $PAR_{linear}$, with only the values of the α terms being different.

An alternative model to that specified in Equation 5 is shown in Equation 6. Equation 6 model eliminates the single β terms and the associated normalization function (the last term in the numerator of Equation 5). The empirical results show that for some configuration cases this model yields smaller estimation errors than the model of Equation 5.

$$CM_{linear} \approx \frac{\sum\limits_{j=1}^{N_I}\alpha_j\beta_{I_j}^2 + \sum\limits_{j=1}^{N_I}\sum\limits_{k=j+1}^{N_I}\alpha_{j,k}\beta_{I_j}\beta_{I_k} + \sum\limits_{j=1}^{N_Q}\alpha_j\beta_{Q_j}^2 + \sum\limits_{j=1}^{N_Q}\sum\limits_{k=j+1}^{N_Q}\alpha_{j,k}\beta_{Q_j}\beta_{Q_k}}{\sum\limits_{j=1}^{N_I}\beta_{I_j}^2 + \sum\limits_{j=1}^{N_Q}\beta_{Q_j}^2}$$

Equation (6)

For a given configuration case, the values of the α terms can be determined by: 1) using a transmitter simulation (230) to measure $CM_{linear}$ and/or $PAR_{linear}$ for all, or a reduced set of exemplar possible signals; and 2) employing the well known method of least squares fitting, which is given in matrix form in Equation 7:

$$\alpha = \left(X^T X\right)^{-1} X^T Y$$

Equation (7)

where;

$X$ is a matrix (known as a design or Vandermode matrix) with one row for each signal, in which each element of a row is the numerical value of a squared, weighted individual or intra-component cross β term. These are all determined by replacing the $\beta_I$ and $\beta_Q$ terms of the numerator of Equation 5 or Equation 6 with specific channel β terms; for the case of two or four E-DPDCHs, the individual and squared $\beta_{ed}$ terms should each occupy only one row of $X$, not two or four; and $Y$ is a column vector with one element for each signal, in which each element is the measured $CM_{linear}$ or $PAR_{linear}$, respectively. Given that the α terms for estimating CM or the α terms for estimating PAR are to be calculated, multiplied by the signal's weighting factor in the denominator of Equation 5 or Equation 6. Alternatively, Y can be a matrix of two such columns, one for $CM_{linear}$ and another for $PAR_{linear}$, given that α terms for estimating both CM and PAR are to be calculated.

The symbolic terms (not their numerical values) used in Equation (7) to compute the α values for this example are provided as:

$$
\bar{L} = \begin{bmatrix} \beta_{d1}^2 + \beta_{ec1}^2 + 2\beta_{ed1}^2 + \beta_{c1}^2 + \beta_{hs1}^2 \\ \beta_{d2}^2 + \beta_{ec2}^2 + 2\beta_{ed2}^2 + \beta_{c2}^2 + \beta_{hs2}^2 \\ \vdots \\ \beta_{d72900}^2 + \beta_{ec72900}^2 + 2\beta_{ed72900}^2 + \beta_{c72900}^2 + \beta_{hs72900}^2 \end{bmatrix} \qquad \text{Equation (8)}
$$

$$
\sqrt{\bar{L}} = \begin{bmatrix} \sqrt{\beta_{d1}^2 + \beta_{ec1}^2 + 2\beta_{ed1}^2 + \beta_{c1}^2 + \beta_{hs1}^2} \\ \sqrt{\beta_{d2}^2 + \beta_{ec2}^2 + 2\beta_{ed2}^2 + \beta_{c2}^2 + \beta_{hs2}^2} \\ \vdots \\ \sqrt{\beta_{d72900}^2 + \beta_{ec72900}^2 + 2\beta_{ed72900}^2 + \beta_{c72900}^2 + \beta_{hs72900}^2} \end{bmatrix} \qquad \text{Equation (9)}
$$

$$
X^T = \begin{bmatrix} \begin{bmatrix} \beta_{ec1} & \beta_{cc2} & \cdots & \beta_{ec\,72900} \\ \beta_{ed1} & \beta_{ed2} & \cdots & \beta_{ed\,72900} \\ \beta_{d1} & \beta_{d2} & \cdots & \beta_{d\,72900} \\ \beta_{c1} & \beta_{c2} & \cdots & \beta_{c\,72900} \\ \beta_{hs1} & \beta_{hs2} & \cdots & \beta_{hs\,72900} \end{bmatrix} \\[2ex] \begin{bmatrix} \beta_{ec1}^2 & \beta_{ec2}^2 & \cdots & \beta_{cc72900}^2 \\ \beta_{ed1}^2 & \beta_{ed2}^2 & \cdots & \beta_{ed\,72900}^2 \\ \beta_{d1}^2 & \beta_{d2}^2 & \cdots & \beta_{d\,72900}^2 \\ \beta_{c1}^2 & \beta_{c2}^2 & \cdots & \beta_{c\,72900}^2 \\ \beta_{hs1}^2 & \beta_{hs2}^2 & \cdots & \beta_{hs\,72900}^2 \\ \beta_{ec1}\beta_{ed1} & \beta_{ec2}\beta_{ed2} & \cdots & \beta_{cc72000}\beta_{ed\,72900} \\ \beta_{ec1}\beta_{d1} & \beta_{ec2}\beta_{d2} & \cdots & \beta_{cc72900}\beta_{d\,72900} \\ \beta_{ed1}\beta_{d1} & \beta_{ed2}\beta_{d2} & \cdots & \beta_{ed\,72900}\beta_{d\,72900} \\ \beta_{c1}\beta_{hs1} & \beta_{c2}\beta_{hs2} & \cdots & \beta_{c\,72900}\beta_{hs\,72900} \\ \beta_{c1}\beta_{ed1} & \beta_{c2}\beta_{ed2} & \cdots & \beta_{c\,72900}\beta_{ed\,72900} \\ \beta_{hs1}\beta_{ed1} & \beta_{hs2}\beta_{ed2} & \cdots & \beta_{hs\,72900}\beta_{ed\,72900} \end{bmatrix} \end{bmatrix} \cdot diag\left(\sqrt{\bar{L}}\right) \qquad \text{Equation (10)}
$$

$$
Y = diag(\bar{L}) \cdot \begin{bmatrix} CM\_linear_1 & PAR\_linear_1 \\ CM\_linear_2 & PAR\_linear_2 \\ \vdots & \vdots \\ CM\_linear_{72900} & PAR\_linear_{72900} \end{bmatrix} \qquad \text{Equation (11)}
$$

$$\hat{Y} = X \cdot \alpha \qquad\qquad \text{Equation (12)}$$

$$err = 10\log(\hat{Y}) - 10\log(Y) \qquad\qquad \text{Equation (13)}$$

The reduced set of possible signals cited above by example refers to the fact that the number of signals necessary to reliably compute the $\alpha$ terms can be orders-of-magnitude less than the number of all possible signals. However, the matrix $X$ with all possible signals is used to calculate the estimation errors using Equations 12 and 13. There is no vital economy realized in the off-line processor 200 by limiting the number of signals in $X$ to compute the $\alpha$ terms.

The weighting factors specified in Equations 5 and 6, which are used to construct the matrices $Y$ and $X$, respectively, the digital power (the denominator of Equation 5 and Equation 6), and root mean square magnitude (the square root term in the numerator of Equation 5) of each signal may, in certain implementations be equivalent or nearly equivalent for all signals. In such case it may not need to be computed for each signal. Instead, the two weighting factors can each be their constant values that are common to all signals.

The weighting factors could also be eliminated from Equations 5 and 6, and be effectively incorporated into the $\alpha$ terms, if the scaling of the digital $\beta$ terms in the transmitter simulation used to measure CM and/or PAR and subsequently calculate the $\alpha$ terms is identical to the scaling of the digital $\beta$ terms in the WTRU.

Using the process of Figures 2 and 3, the $\alpha$ terms for all of the defined configuration cases, an adjustment factor for each configuration case, and the model which minimizes the maximum-MPR or minimum-MPR estimation error have been computed for the two models described in Equations 5 and 6. The model which minimizes the maximum-MPR or minimum-MPR estimation error is computed as follows:

For the case of maximum-MPR, there are three alternatives for determining the model that minimizes the maximum-MPR estimation error.

The first alternative is that the estimated $CM_{linear}$ from Equations 5 or 6 should be adjusted such that an adjusted estimated CM can not be greater than the value which would have been obtained from actual measurement of CM. The adjustment factor should be the largest magnitude positive error for the particular configuration case; it should in effect be subtracted from the actual estimate. The intent of adjusting the estimate in this manner is to prevent overestimating CM for any signal.

The second alternative is that the estimated $CM_{linear}$ from Equations 5 or 6 should be adjusted such that the maximum-MPR determined from an adjusted estimated CM can not be greater than the maximum-MPR which would have been obtained from actual measurement of CM. The intent of adjusting the estimate in this manner is to prevent overestimating maximum-MPR for any signal. The method of determining the adjustment factor follows.

1) For each signal in the configuration, determine the estimated MPR using the estimated CM and determine the true MPR from the known simulated true CM.

2) Compute MPR error as per Equation 14:

$$MPR\_error = MPR\_true - MPR\_estimated$$

$$\text{Equation (14)}$$

3) From amongst the signals with MPR error less than zero, select as the raw adjustment factor per Equation 15:

$$adjustment\_factor\_raw = \max\left(CM\_estimated - ceil(CM\_true, 0.5)\right);$$

$$\text{Equation (15)}$$

where, ceil $(\cdot, 0.5)$ means rounding upwards to the closest 0.5.

4) The final adjustment value is the value from Equation 15 plus a small quantity, $\varepsilon$, which ensures that for the signal with the maximum *CM_ estimated* in Equation 15 does not get rounded up to the next 0.5 dB after applying the adjustment factor. In other words, the adjustment factor is calculated using Equation 16, in which the maximum is selected from amongst the signals with MPR error that is less than zero.

$$adjustment\_factor = \max\big(CM\_estimated - ceil(CM\_true, 0.5)\big) + \varepsilon$$

Equation (16)

The third alternative is that a smaller-magnitude adjustment factor than those per the other alternatives be applied, the amount selected as a design trade-off, (e.g., preventing overestimation of CM for only particular signals of a configuration case).

For the case of computing minimum-MPR for determining the model that minimizes the minimum-MPR estimation error, the estimated CM or PAR should be adjusted such that an adjusted estimated CM or PAR can not be less than the value of actual measurement of CM or PAR. The adjustment factor should be the largest magnitude negative CM or PAR estimation error for the particular configuration case; it should in effect be subtracted from the actual estimate. The intent of applying the adjustment factor in this manner is to prevent underestimating CM or PAR for any signal. Alternatively, a smaller-magnitude negative adjustment factor could be applied, the amount selected as a design trade-off, (e.g., preventing underestimation of CM or PAR for only particular signals of a configuration case).

For each configuration case, after the application of the adjustment factor by either method, an evaluation must be made as to whether the errors are sufficiently small for both models. Examples of the distribution of measurement errors for a particular configuration case are given in Figures 5A, 5B, 6A, 6B, 7A and 7B. Figures 5A, 6A, and 7A represent the model described in Equation 5; and, Figures 5B, 6B, and 7B represent the model described in Equation 6. Figures 5A and 5B show the distribution of maximum-MPR estimation errors for a particular case. In Figures 5A and 5B, due to the ceil operation in the computation of maximum-MPR, the distribution is highly quantized.

Figures 6A and 6B show the density of CM estimation errors; Figure 6A has a narrower density compare to Figure 6B. The distributions in Figures 6A and 6B, and Figures 7A and 7B are essentially continuous. Figures 7A and 7B show the density of the errors of estimating PAR. For computing maximum-MPR, the maximum maximum-MPR error should be within a desired limit. Alternatively, the difference between the extreme positive and negative CM measurement errors being within a desired limit could be the criteria. However, using the maximum maximum-MPR error is preferable. For computing minimum-MPR using CM or PAR, the difference between the extreme positive and negative measurement errors should be within a desired limit.

For the maximum-MPR, applying the adjustment factor per the first alternative results in no signal having overestimated MPR and some signals having underestimated MPR. Applying the adjustment factor per the second alternative results in no signal having overestimated CM and some signals having underestimated CM. Specifically, the signal with the largest positive CM error will have CM correctly estimated, the signal with the largest magnitude negative CM error will have CM underestimated by the difference between the largest magnitude positive and negative CM errors, and other signals will have CM underestimated by some lesser amount.

For minimum-MPR, applying the adjustment factor results in no signal having underestimated CM or PAR; and some signals having overestimated CM or PAR. Specifically, the signal with the largest positive CM or PAR error will have CM or PAR correctly estimated; the signal with the largest magnitude positive CM or PAR error will have CM or PAR overestimated by the difference between the largest magnitude positive and negative CM errors.

There are two potential problems with estimation errors: First, due to the deliberate underestimation and overestimation of CM and PAR, calculated minimum-MPR may exceed calculated maximum-MPR. In which case, the WTRU may not select a value of MPR that would ensure compliance with both the MPR and ACLR requirements of a standard, for example, 3GPP. Second, the larger the difference of largest magnitude positive and negative estimation errors, the greater is the difference between minimum-MPR obtained per the method and minimum-MPR hypothetically obtainable by measurement, reducing the highest achievable maximum transmit power.

Two possible remedies for these issues are: 1) the tradeoff described above could be applied by selecting alternative adjustment factor values such that for some presumably small set of signals the computed MPR is not compliant; and 2) the particular configuration case could be broken in two or more configuration cases, with the goal that the resulting estimation errors would be smaller. For example, if analysis revealed that the largest estimation errors occur for the largest $\beta$ values for a particular physical channel, a separate configuration case could be created with only those $\beta$ values.

Once a set of configuration cases has been defined and the $\alpha$ terms and adjustment factors for all of the configuration cases have been computed, they are preferably stored in a table in a WTRU.

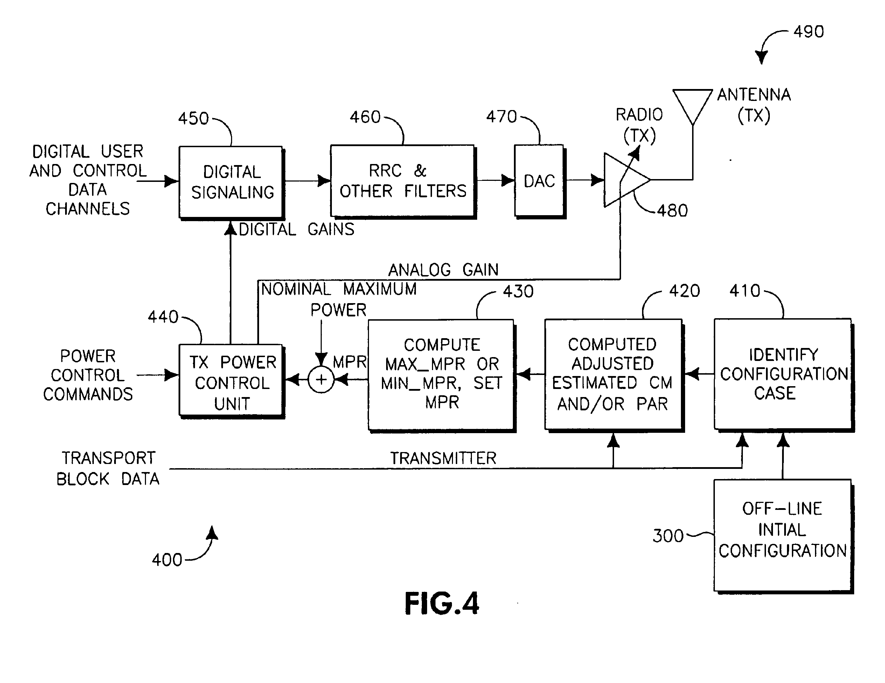

Referring to Figure 4, a WTRU 400 is shown. Prior to the start of transmission of each TTI, an appropriate configuration case is selected given the data supplied by Medium Access Control (MAC) layer of the transport block. For the definition of the set of configuration cases given in Table 1, selection would be per the mix of physical channels to be used to transmit the transport block, and possibly the E-DPDCH spreading factor.

Whether the MPR computation device (430) computes maximum-MPR, minimum-MPR or both, and, if the device computes minimum-MPR using PAR, $CM_{linear}$ is estimated per Equation 17, a simplified version of Equation 5 and Equation 6:

$$CM_{linear} \approx \frac{N}{D}; \qquad\qquad \text{Equation (17)}$$

where N and D are a numerator and a denominator of Equation 5 or Equation 6, respectively, using the CM α terms of the configuration case determined hereinabove. $PAR_{linear}$ is estimated using Equation 11, but replacing $CM_{linear}$ with $PAR_{linear}$ and using the PAR α terms of the configuration case. $CM_{linear}$ and/or $PAR_{linear}$ is then converted to dB form.

If the MPR computation device (430) computes maximum-MPR, the adjustment factor (in dB) selected for computing maximum-MPR is subtracted from the estimate of CM in dB. This gives the value of CM that is used to compute maximum-MPR.

If the MPR computation device (430) computes minimum-MPR using CM, the adjustment factor (in dB) selected for computing minimum-MPR using CM is subtracted from the estimate of CM in dB. This results in using the value of CM to compute the minimum-MPR.

If the MPR computation device (430) computes minimum-MPR using PAR, the adjustment factor (in dB) selected for computing minimum-MPR using PAR is subtracted from the estimate of PAR in dB and the result is used to compute minimum-MPR.

If the MPR computation device computes maximum-MPR, maximum-MPR is preferably computed per 3GPP. If the MPR computation device computes minimum-MPR, minimum-MPR is preferably computed per the power amplifier's specification.

A device computing either maximum-MPR or minimum-MPR, but not both, would output the computed maximum-MPR or minimum-MPR as the value of MPR used to set transmit power. A device computing both maximum-MPR and minimum-MPR could choose some intermediate value as the value of MPR used to set transmit power and remain compliant to the standard and to the manufacturer's recommendation.

It is not necessary to actually fully estimate the value of CM, but only detect if the estimated value of CM is above or below one or more threshold values. One possible threshold test that has the advantage of avoiding the divide operation in Equation 17 can be made by slightly modifying Equation 17 as provided in Equation 18.

$$CM_{linear\,T} \cdot D \overset{?}{<} N$$

$$\text{Equation (18)}$$

where; $CM_{linear}T$ is a particular threshold value of $CM_{linear}$; the < operator is a threshold test indicating that $CM_{linear}$ is greater than $CM_{linear}T$ if the inequality is "true".

The efficient algorithm given in C language notation setting the values of max_MPR_dB and the threshold values which are shown in Table 4 are derived from Table 6.1A of 3GPP TS 25.101. The values of linear equivalents of the adjustment factors are selected for computation of maximum-MPR.

**Table 4**

| Index | CM_linear_T | MPR_dB |
|---|---|---|
| 0 | 10^(1.0/10)=1.258925 | Not Used |
| 1 | 10^(1.5/10)=1.412538 | 0.5 |
| 2 | 10^(2.0/10)=1.584893 | 1.0 |
| 3 | 10^(2.5/10)=1.778279 | 1.5 |
| 4 | 10^(3.0/10)=1.995262 | 2.0 |

(continued)

| Index | CM_linear_T | MPR_dB |
|---|---|---|
| 5 | Not Used | 2.5 |

A device-specific method for computing minimum-MPR is likely to compute similarly to maximum-MPR based on some number, possibly only one, threshold values of CM and/or PAR, and a similar algorithm can be used to compute it.

Referring back to Figure 4, which is a WTRU 400 configured for use for wireless communication, digital user data and control data are received and processed by the scaling circuitry 450 to digitally scale the data to set their relative transmit powers. The digital user data may be encoded into channels such as in dedicated physical data channels (DPDCHs) or in enhanced DPDCHs (E-DPDCHs). The control data may be encoded into channels such as in dedicated physical control channels (DPCCHs), high speed DPCCHs (HS-DPCCHs) or enhanced DPCCHs (E-DPCCHs). The scaling circuitry 450 operates on these respective channels.

The scaled data is filtered by filtering devices 460 and this filtered data is converted to an analog signal by a digital-to-analog converter (DAC) 470 and transmitted by the radio transmitter 480 through the antenna (Tx) 490. The WTRU's transmitter has adjustable, (i.e., power controllable), overall transmit power as well as scalable individual channel inputs, as represented in Figure 4 by the analog gains value number and digital gains value number, respectively. Other variations of a controllable transmission device may be employed.

The transmit power of the individual channels and the total transmit power are set based upon the procedures specified in 3GPP by the transmit power control unit 440. The nominal maximum transmit power is determined by the WTRU power class or by the network. Maximum transmit power for the WTRU power classes are those as specified in 3GPP. The WTRU may autonomously limit its maximum transmit power by maximum-MPR, a value within the limits defined in 3GPP, or by a lesser device-specific minimum-MPR.

The transmit power control unit 440 sets the transmit power using multiple parameters. One of these parameters is MPR. To computer the MPR, first a configuration case is identified based on the off-line configuration parameters obtained as described hereinabove with respect to Figures 2 and 3 (410). For the identified case, adjusted estimated CM and/or PAR is computed (420) as described hereinafter.

An MPR is set based on a value for maximum-MPR and/or minimum-MPR (430). The maximum-MPR and/or minimum-MPR is preferably computed by a processing device 430 based on an adjusted estimate of CM and/or PAR (420), or an adjusted estimate to MPR. If it is computed based on the adjustment to MPR then there are no adjustments made to CM and/or PAR.

**[0097]** The WTRU 400 can be configured to compute either or both MPRs; and to compute minimum-MPR from either CM or PAR such that the use of any such combination is selectable. The estimation of CM and/or PAR may be a function of pre-computed terms, denoted as $\alpha$ terms, and functions of the desired relative channel powers ($\beta$ terms) of the transmitted signal, where the particular functions of the $\beta$ terms are based on the certain physical parameters of the signal. The adjustment of the estimate may be from a pre-computed term.

To compute either or both MPRs in the WTRU 400, First, for a TTI, the signal is of the example configuration, with channel weights from MAC-es being $\beta_c = 15$, $\beta_d = 6$, $A_{hs} = \beta_{hs}/\beta_c = \max (\Delta_{ACK}$ and $\Delta_{CQI}) = 15/15$, $A_{ec} = \beta_{ec}/\beta_c$ $= 15/15$, $A_{ed}, = \beta_{ed}/\beta_c = 95/15$. This example signal is signal U in R4-060176, 3GPP TSG RAN 4 Meeting #38.

Second, using digital scaling the WTRU 400 computes the following digital channel weights: $\beta_c = 22$, $\beta_d = 9$, $\beta_{hs} = 22$, $\beta_{ec} = 22$, $\beta_{ed} = 200$. These weights are in the desired proportion to each other and the sum of their squares is a desired constant value.

Third, using the $\alpha_{CM}$ and $\beta$ terms in Table 3, the digital channel weights and the estimate of $CM_{linear}$ are computed using Equation 5 as 1.0589, equivalent to 0.2487 dB.

Fourth, the estimate of CM is adjusted by subtracting 0.54 dB, yielding approximately -0.29 dB. Alternatively, in linear form, the estimate is adjusted by multiplying 1.0589 by 0.883, yielding approximately 0.93.

Fifth, the linear adjusted estimate of CM, 0.94, is less than the first linear threshold in Table 4; hence, maximum-MPR is computed as 0 dB.

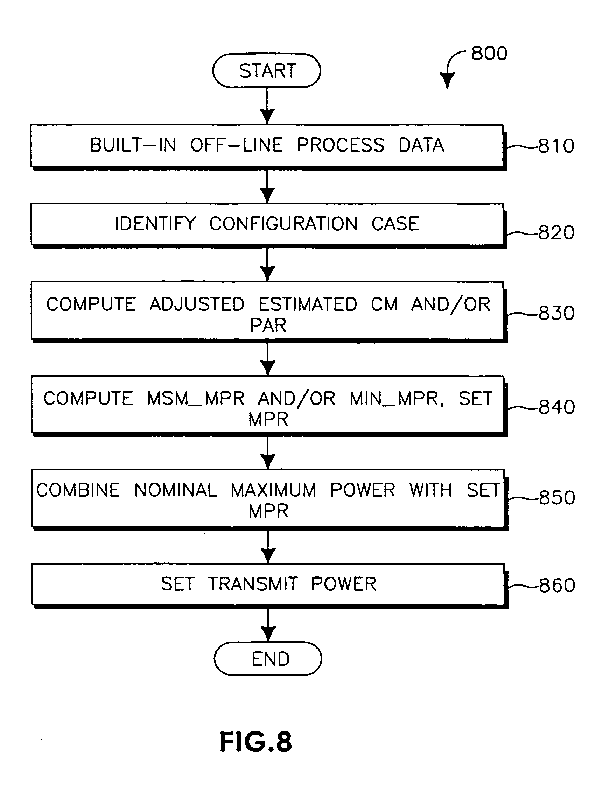

To summarize by referring to Figure 8, a procedure 800 for setting transmit power by computing MPR in the WTRU 400 is shown. Per a configuration case adjustment factors and the pre-computed $\alpha$ values are determined and processed in an off-line processor (810). These values are stored in the WTRU 400 to help the WTRU 400 identify a configuration case (820). Once a configuration case is determined, adjusted estimated CM and/or PAR are computed (830). Using these adjusted estimated values, maximum-MPR and/or minimum-MPR are computed (840), and an MPR is set. The MPR, nominal maximum power, and the Power Control Commands are combined (850) and the transmit power is set (860).

Although the features and elements are described in the embodiments in particular combinations, each feature or element can be used alone without the other features and elements or in various combinations with or without other features and elements. The methods or flow charts provided may be implemented in a computer program, software, or firmware tangibly embodied in a computer-readable storage medium for execution by a general purpose computer or a processor. Examples of computer-readable storage mediums include a read only memory (ROM), a random access memory (RAM), a register, cache memory, semiconductor memory devices, magnetic media such as internal hard disks and removable disks, magneto-optical media, and optical media such as CD-ROM disks, and digital versatile disks (DVDs).

Suitable processors include, by way of example, a general purpose processor, a special purpose processor, a conventional processor, a digital signal processor (DSP), a plurality of microprocessors, one or more microprocessors in association with a DSP core, a controller, a microcontroller, Application Specific Integrated Circuits (ASICs), Field Programmable Gate Arrays (FPGAs) circuits, any other type of integrated circuit (IC), and/or a state machine.

A processor in association with software may be used to implement a radio frequency transceiver for use in a wireless transmit receive unit (WTRU), user equipment (UE), terminal, base station, radio network controller (RNC), or any host computer. The WTRU may be used in conjunction with modules, implemented in hardware and/or software, such as a camera, a video camera module, a videophone, a speakerphone, a vibration device, a speaker, a microphone, a television transceiver, a hands free headset, a keyboard, a Bluetooth® module, a frequency modulated (FM) radio unit, a liquid crystal display (LCD) display unit, an organic light-emitting diode (OLED) display unit, a digital music player, a media player, a video game player module, an Internet browser, and/or any wireless local area network (WLAN) module.

**Claims**

1.  A method implemented in a wireless transmit receive unit, WTRU, for computing a maximum power reduction, MPR, the method being **characterized in** comprising:

    identifying (820) a configuration case from a set of configuration cases predefined according to characteristics of a received signal;
    adjusting (830) an estimated cubic metric, CM, by a preconfigured adjustment factor for the configuration case, where the CM is based on a transmit power amplifier cubic gain term and the estimated CM is stored in the WTRU from an initial configuration;
    computing (840) the MPR based on the adjusted estimated CM; and
    setting (840) transmit power using the MPR.

2.  A method as in claim 1, wherein the transmit power is set using the computed MPR along with a nominal maximum power limit and at least one power control command.

3.  The method as in claim 1, wherein the configuration case is defined by a channelization code of the received signal and a channel weight for an in-phase (I) channel code and a quadrature channel (Q) code of the received signal.

4.  A wireless transmit receive unit, WTRU (120), being **characterized in** comprising a processor (125), the processor configured to:

    identify a configuration case from a set of configuration cases predefined according to characteristics of a received signal;
    adjust an estimated cubic metric (CM) by a preconfigured adjustment factor for the configuration case, where the CM is based on a transmit power amplifier cubic gain term and the estimated CM is stored in the WTRU from an initial configuration;
    compute the MPR based on the adjusted estimated CM; and
    set transmit power using the MPR.

5.  A WTRU (120) as in claim 4, wherein the transmit power is set using the computed MPR along with a nominal maximum power limit and at least one power control command.

6.  The WTRU (120) as in claim 4, wherein the configuration case is defined by a channelization code of the received signal and a channel weight for an in-phase (I) channel code and a quadrature channel (Q) code of the received signal.

7.  The WTRU (120) as in claim 4, wherein the processor (125) is further configured to:

    set an adjustment factor that is a largest magnitude positive error of a configuration case for a channel.

8. The WTRU (120) as in claim 7, wherein a smaller magnitude adjustment factor is selected.

9. The WTRU (120) as in claim 4, wherein the processor (125) is further configured to compute the CM as a weighted version of an inner product of a squared weighted-individual, intra-component cross β terms in respect of a component of the received signal, where β represents strength of the signal.

10. The WTRU (120) as in claim 4, wherein the processor (125) is further configured to compute the CM as a weighted version of an inner product of a squared weighted-individual, intra-component cross β terms in respect of a component of the received signal, including normalized single β terms that are not intra-component, where β represents strength of the signal.

11. The WTRU (120) as in claim 4, wherein the processor (125) is further configured to:

   determine an adjustment factor for minimizing a maximum MPR estimation error by:

      determining an estimated MPR and a true MPR for each signal in the configuration case;
      computing an MPR error by subtracting the estimated MPR from the true MPR; and
      selecting the adjustment factor value as the signal with MPR error that is less than zero.

12. The WTRU (120) as in claim 11, wherein a magnitude ajustment factor is selected.

13. A WTRU (120) as in claim 4, wherein the processor (125) is further configured to:

   set an adjustment factor that is a largest magnitude negative error of a configuration case.


**Patentansprüche**

1. Verfahren zum Berechnen einer maximalen Leistungsreduktion MPR, welches in einer drahtlosen Sendeempfangseinheit WTRU implementiert ist, **dadurch gekennzeichnet, dass** das Verfahren umfasst:

   Identifizieren (820) eines Konfigurationsfalls aus einem Satz von gemäß den Merkmalen eines empfangenen Signals vordefinierten Konfigurationsfällen;
   Anpassen (830) einer geschätzten kubischen Metrik CM mit einem vorkonfigurierten Anpassungsfaktor für den Konfigurationsfall, wobei die CM auf einem Ausdruck für kubische Verstärkung eines Sendeleistungsverstärkers basiert, und die geschätzte CM aufgrund einer anfänglichen Konfiguration in der WTRU gespeichert wird;
   Berechnen der (840) der MPR auf Basis der angepassten geschätzten CM; und
   Einstellen (860) der Sendeleistung unter Einsatz der MPR.

2. Verfahren nach Anspruch 1, wobei die Sendeleistung unter Einsatz der berechneten MPR zusammen mit einer nominalen maximalen Leistungsgrenze und mindestens einem Leistungssteuerungsbefehl eingestellt wird.

3. Verfahren nach Anspruch 1, wobei der Konfigurationsfall durch einen Kanalisierungscode des empfangenen Signals und ein Kanalgewicht für einen Inphasen-Kanalcode (I) und einen Quadraturkanalcode (Q) des empfangenen Signals definiert wird.

4. Drahtlose Sendeempfangseinheit WTRU (120), **dadurch gekennzeichnet, dass** sie einen Prozessor (125) umfasst und der Prozessor konfiguriert ist,
   einen Konfigurationsfall aufgrund eines Satzes von Konfigurationsfällen zu identifizieren, die gemäß den Merkmalen eines empfangenen Signals vordefiniert wurden;
   eine kubische Metrik (CM) mit einem vorkonfigurierten Anpassungsfaktur für den Konfigurationsfall anzupassen, wobei die CM auf einem Ausdruck für kubische Verstärkung eines Sendeleistungsverstärkers basiert, und die geschätzte CM aufgrund einer anfänglichen Konfiguration in der WTRU gespeichert wird,
   die MPR auf Basis der angepassten geschätzten CM zu berechnen; und
   die Sendeleistung unter Einsatz der MPR einzustellen.

5. WTRU (120) nach Anspruch 4, wobei die Sendeleistung unter Einsatz der berechneten MPR zusammen mit einer nominalen maximalen Leistungsgrenze und mindestens einem Leistungssteuerungsbefehl eingestellt wird.

6. WTRU (120) nach Anspruch 4, wobei der Konfigurationsfall durch einen Kanalisierungscode des empfangenen Signals und ein Kanalgewicht für einen Inphasen-Kanalcode (I) und einen Quadraturkanalcode (Q) des empfangenen Signals definiert wird.

7. WTRU (120) nach Anspruch 4, wobei der Prozessor (125) ferner konfiguriert ist, einen Anpassungsfaktor einzustellen, der ein positiver Fehler größter Größenordnung eines Konfigurationsfalls für einen Kanal ist.

8. WTRU (120) nach Anspruch 7, wobei ein Anpassungsfaktor kleinerer Größe ausgewählt wird.

9. WTRU (120) nach Anspruch 4, wobei der Prozessor (125) ferner konfiguriert ist, die CM als gewichtete Version eines Innenprodukts eines quadrierten individuell gewichteten Intra-component cross β Ausdrucks mit Bezug auf eine Komponente des empfangenen Signals zu berechnen, wobei β die Stärke des Signals darstellt.

10. WTRU (120) nach Anspruch 4, wobei der Prozessor (125) ferner konfiguriert ist, die CM als gewichtete Version eines Innenprodukts eines quadrierten individuell gewichteten Intra-component cross β Ausdrucks mit Bezug auf eine Komponente des empfangenen Signals einschließlich normalisierter einzelner β Ausdrücke, die nicht Intra-component sind, zu berechnen, wobei β die Stärke des Signals darstellt.

11. WTRU (120) nach Anspruch 4, wobei der Prozessor (125) ferner konfiguriert ist,
einen Anpassungsfaktor zum Minimieren eines maximalen MPR Schätzungsfehlers zu bestimmen durch:

Bestimmen einer geschätzten MPR und einer echten MPR für jedes Signal im Konfigurationsfall;
Berechnen eines MPR-Fehlers durch Subtrahieren der geschätzten MPR von der echten MPR; und
Auswählen des Anpassungsfaktorwerts als Signal mit MPR Fehler, der kleiner als Null ist.

12. WTRU (120) nach Anspruch 11, wobei ein Anpassungsfaktor kleinerer Größe ausgewählt wird.

13. WTRU (120) nach Anspruch 4, wobei der Prozessor (125) ferner konfiguriert ist,
einen Anpassungsfaktor einzustellen, der ein negativer Fehler größter Größe eines Konfigurationsfalls ist.


**Revendications**

1. Procédé mis en oeuvre dans une unité d'émission réception sans fil, WTRU, pour calculer une réduction de puissance maximum, MPR, le procédé étant **caractérisé en ce qu'**il comprend :

l'identification (820) d'un cas de configuration parmi un jeu de cas de configuration prédéfinis en fonction des caractéristiques d'un signal reçu ;
l'ajustement (830) d'une métrique cubique, CM, estimée par un facteur d'ajustement préconfiguré pour le cas de configuration, où la CM est basée sur un terme de gain cubique d'amplificateur de puissance d'émission et la CM estimée est stockée dans la WTRU à partir d'une configuration initiale ;
le calcul (840) de la MPR sur la base de la CM estimée ajustée ; et
le réglage (860) de la puissance d'émission en utilisant la MPR.

2. Procédé selon la revendication 1, dans lequel la puissance d'émission est réglée en utilisant la MPR calculée avec une limite de puissance maximum nominale et au moins une commande de contrôle de puissance.

3. Procédé selon la revendication 1, dans lequel le cas de configuration est défini par un code de canalisation du signal reçu et un poids de canal pour un code de canal en phase (I) et un code de canal en quadrature (Q) du signal reçu.

4. Unité d'émission réception sans fil, WTRU, (120) étant **caractérisée en ce qu'**elle comprend un processeur (125), le processeur étant configuré pour :

identifier un cas de configuration parmi un jeu de cas de configuration prédéfinis en fonction des caractéristiques d'un signal reçu ;
ajuster une métrique cubique, CM, estimée par un facteur d'ajustement préconfiguré pour le cas de configuration, où la CM est basée sur un terme de gain cubique d'amplificateur de puissance d'émission et la CM estimée est stockée dans la WTRU à partir d'une configuration initiale ;

calculer la MPR sur la base de la CM estimée ajustée ; et

régler la puissance d'émission en utilisant la MPR.

**5.** WTRU (120) selon la revendication 4, dans laquelle la puissance d'émission est réglée en utilisant la MPR calculée avec une limite de puissance maximum nominale et au moins une commande de contrôle de puissance.

**6.** WTRU (120) selon la revendication 4, dans laquelle le cas de configuration est défini par un code de canalisation du signal reçu et un poids de canal pour un code de canal en phase (I) et un code de canal en quadrature (Q) du signal reçu.

**7.** WTRU (120) selon la revendication 4, dans laquelle le processeur (125) est en outre configuré pour :

régler un facteur d'ajustement qui est une erreur positive de grandeur maximale d'un cas de configuration pour un canal.

**8.** WTRU (120) selon la revendication 7, dans laquelle un facteur d'ajustement de grandeur inférieure est sélectionné.

**9.** WTRU (120) selon la revendication 4, dans laquelle le processeur (125) est en outre configuré pour calculer la CM en tant que version pondérée d'un produit intérieur des termes $\beta$ croisés à intra-composants à pondération individuelle au carré par rapport à un composant du signal reçu, où $\beta$ représente la force du signal.

**10.** WTRU (120) selon la revendication 4, dans laquelle le processeur (125) est en outre configuré pour calculer la CM en tant que version pondérée d'un produit intérieur des termes $\beta$ croisés à intra-composants à pondération individuelle au carré par rapport à un composant du signal reçu, comprenant des termes $\beta$ uniques normalisés qui ne sont pas un intra-composant, où $\beta$ représente la force du signal.

**11.** WTRU (120) selon la revendication 4, dans laquelle le processeur (125) est en outre configuré pour :

déterminer un facteur d'ajustement pour minimiser une erreur d'estimation MPR maximum en :

déterminant une MPR estimée et une MPR réelle pour chaque signal dans le cas de configuration ;
calculant une erreur de MPR en soustrayant la MPR estimée à la MPR réelle ; et
sélectionnant la valeur de facteur d'ajustement en tant que signal avec une erreur de MPR inférieure à zéro.

**12.** WTRU (120) selon la revendication 11, dans laquelle un facteur d'ajustement de grandeur inférieure est sélectionné.

**13.** WTRU (120) selon la revendication 4, dans laquelle le processeur (125) est en outre configuré pour :

régler un facteur d'ajustement qui est une erreur négative de grandeur maximale d'un cas de configuration.

**FIG.1**

EP 2 140 571 B1

**FIG.2**

```
        ╭─────────╮                    ╭─ 300
        (  START  )                  ╱
        ╰─────────╯              ◢
             │
             ▼
   ┌────────────────────────────────┐
   │ DEFINE  AT  LEAST  ONE  CONFIGURATION  CASE │──310
   └────────────────────────────────┘
             │
             ▼
   ┌────────────────────────────────┐
   │ DETERMINE  ALL  COMBINATIONS  OF  THE │
   │ QUANTIZED  β  TERMS  FOR  THE  CHANNELS │──320
   └────────────────────────────────┘
             │
             ▼
   ┌────────────────────────────────┐
   │ MEASURE  CM  AND  PAR  FOR  ALL  SIGNALS │──330
   └────────────────────────────────┘
             │
             ▼
   ┌────────────────────────────────┐
   │ CALCULATE  ESTIMATED  VALUES  OF  α  USING │
   │ SOME  OR  ALL  SIGNALS │──340
   └────────────────────────────────┘
             │
             ▼
   ┌────────────────────────────────┐
   │ ESTIMATE  LINEAR  CM  AND  LINEAR  PAR  FOR │
   │ EACH  SIGNAL │──350
   └────────────────────────────────┘
             │
             ▼
   ┌────────────────────────────────┐
   │ ESTIMATE  ERRORS  FOR  CM  AND  PAR │──360
   └────────────────────────────────┘
             │
             ▼
   ┌────────────────────────────────┐
   │ DETERMINE  ADJUSTMENT  FACTORS  CM │
   │ AND  PAR │──370
   └────────────────────────────────┘
             │
             ▼
   ┌────────────────────────────────┐
   │ DETERMINE  DISTRIBUTION  OF  MAXIMUM_MPR │
   │ ERROR │──380
   └────────────────────────────────┘
             │
             ▼
   ┌────────────────────────────────┐
   │ STORE  CONFIGURATION  CASE,  α  VALUES, │
   │ AND  ADJUSTED  FACTORS  IN  WTRUs │──390
   └────────────────────────────────┘
             │
             ▼
        ╭─────────╮
        (   END   )
        ╰─────────╯
```

**FIG.3**

490

ANTENNA
(TX)

RADIO
(TX)
480

DAC
470

RRC &
OTHER FILTERS
460

DIGITAL
SIGNALING
450

DIGITAL USER
AND CONTROL
DATA
CHANNELS

DIGITAL GAINS

ANALOG GAIN

NOMINAL MAXIMUM
POWER

MPR

IDENTIFY
CONFIGURATION
CASE
410

OFF-LINE
INTIAL
CONFIGURATION
300

COMPUTED
ADJUSTED
ESTIMATED CM
AND/OR PAR
420

COMPUTE
MAX_MPR OR
MIN_MPR, SET
MPR
430

TX POWER
CONTROL
UNIT
440

POWER
CONTROL
COMMANDS

TRANSMITTER

TRANSPORT
BLOCK DATA

400

FIG.4

FIG.5A

FIG.5B

PDF(CM ERROR)

**FIG.6A**

PDF(CM ERROR,dB)

**FIG.6B**

FIG.7A

FIG.7B

FIG.8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1617575 A